# FASCICULE DE BREVET EUROPEEN

(11) **EP 0 321 896 B1**
(45) Date de publication et mention de la délivrance du brevet: **03.03.1993**
(21) Numéro de dépôt: 88121205.4
(22) Date de dépôt: 19.12.1988
(51) Int. Cl.: G06F 1/02, H03K 3/78

(54) **Générateur de signal temporel périodique genre fractal**
Generator für periodische Zeitsignale des Fractaltyps
Fractal-type periodic time signal generator

(30) Priorité: 21.12.1987 FR 8717809
(43) Date de publication de la demande: 28.06.1989
(73) Titulaire: ALCATEL ALSTHOM COMPAGNIE GENERALE D'ELECTRICITE, 75382 Paris Cédex 08 (FR)
(72) Inventeur: Le Mehaute, Alain, F-91190 Gif sur Yvette (FR); Roques-Carmes, Claude, F-25000 Besancon (FR); Wehbi, Dalloul, F-25000 Besancon (FR); Quiniou, Jean-François, F-25000 Besancon (FR)
(74) Mandataire: Weinmiller, Jürgen

(56) Documents cités:
- DE-A- 2 618 823
- GB-A- 2 176 678
- L'ONDE ELECTRIQUE, vol. 58, no. 11, novembre 1978, pages 747-756; P. MINOT et al.: "Séquences anharmoniques"

## Description

La présente invention concerne les signaux temporels périodiques dont la configuration sur une période est définie par un arrangement de motifs précurseurs de différents types résultant d'une construction récursive mettant en oeuvre, par applications successives, des lois récurrentes de composition d'éléments de motif engendrant à chaque nouvelles itérations des motifs de plus en plus complexes. D'une manière générale, la configuration sur une période d'un signal temporel résultant de ce genre de construction arborescente peut être considérée comme une composante "an" du n ième terme Un à m composantes (an, bn, cn,...) d'une suite récurrente, ce n ième terme étant défini au niveau de chacune de ses composantes (an, bn, cn...) en fonction des composantes (a (n-1), b (n-1), c (n-1),...) du terme précédent Un-1 par les arrangements des lois récurrentes de composition de types de motif et le terme initial Uo de la suite ayant pour composantes (ao, bo, co...) les motifs précurseurs.

Le processus de construction arborescente permet d'accroître la complexité du motif obtenu d'une itération à l'autre d'une manière extrêmement rapide. Grâce à lui on obtient, en peu d'itérations, un motif de signal présentant l'apparence générale d'un bruit alors qu'il est en fait très structuré et possède des propriétés de similitude interne complexe résultant du processus d'itération. Le signal temporel résultant présente en raison de ces caractéristiques, des applications intéressantes dans diverses techniques telles que celles des tests vibratoires, des transducteurs et stimulateurs, du dépôt de couches électrochimiques par courants pulsés, de synthèse chimique de systèmes désordonnés, modulations optiques etc...

Les signaux connus sous le nom générique de fractal temporel résultent d'une constructions arborescente de ce genre.

La présente invention a pour but un générateur de signal temporel périodique permettant d'engendrer une grande diversité de signaux périodiques dont la période est à structure récursive du type précité avec une grande rapidité de définition.

Selon l'invention, le générateur temporel périodique est du type dont le motif de configuration périodique est défini par un arrangement de motifs précurseurs résultant d'une construction récurrente mettant en oeuvre, par itérations, plusieurs lois récurrentes de compositions de types motif et consistant à définir ledit motif de configuration périodique comme l'une des composantes "an" du n ième terme Un à m composantes, m étant un entier plus grand que 1, d'une suite récurrente, ledit n ième terme Un étant défini au niveau de chacune de ses composantes en fonction des composantes du terme précédent U(n-1) par m lois récurrentes de composition de types de motif par concaténation des composantes du terme précédent U(n-1) et le terme initial Uo de la suite ayant pour composantes les motifs précurseurs, ledit générateur comportant un microprocesseur associé à une mémoire de travail renfermant un fichier de motif définitif qui contient un arrangement final de motifs précurseurs constituant ledit motif de configuration périodique et qui est lu de manière répétitive lors de la délivrance du signal, et à un périphérique de sortie délivrant ledit signal avec des valeurs successives en accord avec celles des motifs précurseurs lus dans le fichier de motif définitif, la mémoire de travail renfermant au moins trois fichiers lors de la détermination d'un motif de configuration périodique d'un signal :
- un fichier dit de motifs anciens mémorisant les décompositions en motifs précurseurs de motifs anciens résultant d'au moins une application aux motifs précurseurs des lois récurrentes de composition de types de motif,
- un fichier dit de motifs précédents mémorisant les décompositions en motifs précurseurs des motifs obtenus au cours de l'étape d'itération précédent celle en cours,
- et un fichier dit de motifs en cours dans lequel les décompositions des motifs en cours de détermination sont inscrites au fur et à mesure, ces décompositions étant obtenues en reprenant celle des motifs anciens, lues dans le fichier de motifs anciens et en remplaçant dans ces dernières les motifs précurseurs par les décompositions des motifs précédents de mêmes types lues dans le fichier de motifs précédents.

De manière avantageuse, le fichier de motifs anciens contient les motifs de base résultant de la première application aux motifs précurseurs des lois récurrentes de composition.

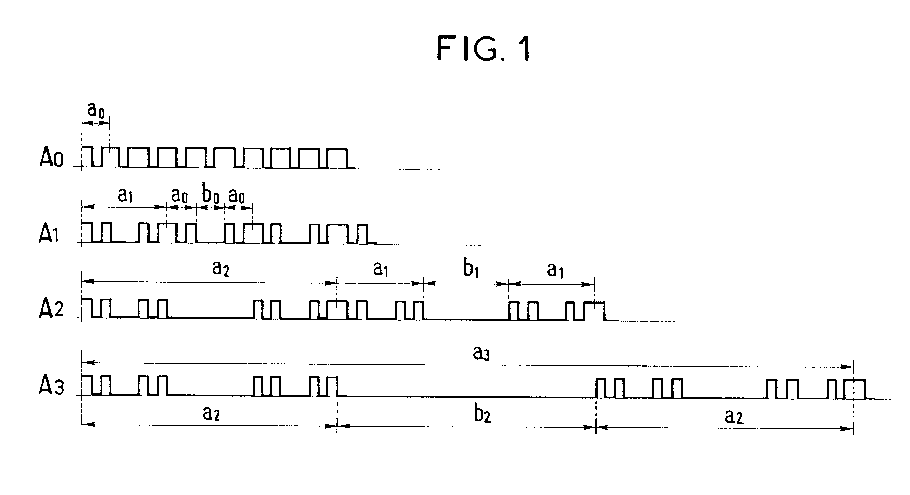

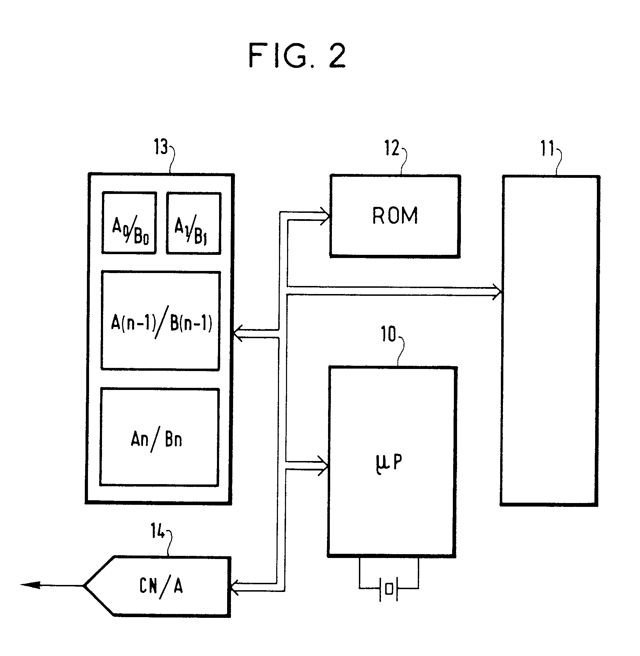

D'autres caractéristiques et avantages de l'invention ressortiront de la description d'un code de réalisation donné à titre d'exemple. Cette description sera faite en regard du dessin dans lequel :
- Une figure 1 est un diagramme de courbes illustrant par des exemples de signaux. L'accroissement extrêmement rapide de la complexité du motif sur une période obtenu par le processus de construction arborescente et,
- Une figure 2 représente un schéma bloc d'un générateur de signal conforme à l'invention permettant de mettre en oeuvre le processus de construction arborescente.

La figure 1 donne un exemple de définition d'un signal binaire temporel par l'intermédiaire d'un suite "an" de valeurs qui représente un échantillonnage régulier de l'une des périodes du signal et qui est obtenue par une construction arborescente mettant en oeuvre deux motifs précurseurs :
ao = 1 0 1
bo = 0 0 0
associés aux deux lois récurrentes de composition de types de motif :
an = an-1 bn-1 an-1
bn = bn-1 bn-1 bn-1
Chaque ième étape de la construction aboutissant à la définition du motif "ai" nécessite la connaissance du couple de motifs a(i-1), b(i-1) obtenu à l'étape antérieure qui peut être considéré comme les composantes d'un terme U(i-1) d'une suite récurrente ayant un terme initial Uo composé des motifs précurseurs ao, bo. La construction d'un motif Un est réalisée par concaténation des composantes a(n-1), b(n-1 du terme précédent U(n-1).

Dans le cas présent, les deux lois de composition adoptées permettent de définir la période du signal binaire obtenu par récursion à partir du motif élémentaire 101 à la manière dont CANTOR fait ses découpages géométriques ou diadiques (cf B. Mandelbrot "the geometry of the nature" Freedmann-1982) et d'obtenir un signal fractal.

La courbe Ao représente à titre d'exemple le signal temporel ayant pour configuration périodique le motif précurseur ao. C'est un signal rectangulaire périodique régulier formé d'impulsions de rapport 2.

La courbe A1 représente à titre d'exemple le signal temporel ayant pour configuration périodique le motif a1 déduit des motifs précurseurs ao, bo après une application des lois récurrentes de composition de types de motifs :
a1 = ao bo ao
a1 = 1 0 1 0 0 0 1 0 1
Ce signal est un signal rectangulaire légèrement irrégulier, avec des impulsions de largeur unitaire et de largeur double et une période trois fois plus longue que le précédent.

La courbe A2 représente le signal temporel ayant pour configuration périodique le motif a2 déduit des motifs précurseurs ao, bo par une double application des lois récurrentes de composition :
a2 = a1 b1 a1
a2 = ao bo ao bo bo bo ao bo ao
a2 = 1 0 1 0 0 0 1 0 1 0 0 0 0 0 0 0 0 0 1 0 1 0 0 0 1 0 1
Ce signal est un signal binaire, nettement plus irrégulier que le précédent, avec des impulsions pour la plupart de largeur unitaire, et une période trois fois plus longue que celle du précédent.

La courbe A2 représente le signal temporel ayant pour configuration périodique le motif a3 déduit des motifs précurseurs ao, bo par une triple application des lois récurrentes de composition de types de motif :
a3 = a2 b2 a2
a3 = a1 b1 a1 b1 b1 b1 a1 b1 a1
a3 = aoboaoboboboaoboaoboboboboboboboboboaoboao...

C'est un signal binaire encore plus irrégulier que le précédent ayant une période de trois fois plus longue que celui-ci.

A chaque nouvelle application des lois récurrentes de composition de types de motif le nombre d'éléments des motifs triple. Cette loi de croissance lui permet d'atteindre rapidement des valeurs très élevées. A la treizième application des lois récurrentes il vaut déjà :
3¹⁴ = 4.782.969
ce qui correspond, pour un signal temporel défini par des impulsions (0,1) se succédant à la cadence de un par seconde, à une période de durée supérieure à mille heures (un mois). Un tel signal a l'apparence d'un bruit alors qu'il est très structuré et formé d'impulsions présentant une organisation cantorienne lui donnant des propriétés de similitude interne quelle que soit l'échelle d'analyse temporelle et qui le rendent particulièrement utile dans diverses techniques telles que la fabrication de macromolécules cantoriennes par électrosynthèse, les tests vibratoires en mécanique destinés à prévoir ou déterminer les comportements à long terme de certains matériaux, par exemple les surfaces de frottement, l'excitation des transducteurs et stimulateurs ainsi que toutes techniques faisant appel classiquement à des considérations spectrales. Il va de soit que les 2 motifs précurseurs peuvent être changé à volonté.

La figure 2 illustre un générateur de signal temporel périodique mettant en oeuvre la construction arborescente prédemment décrite pour la définition du signal sur une période. Ce générateur comporte essentiellement un microprocesseur 10 associé à un ensemble clavier afficheurs 11, à une mémoire morte 12 de programme, à une mémoire vive 13 de travail et à un convertisseur numérique-analogique 14 de sortie.

Le microprocesseur 10 assure, sous la commande de programmes inscrits en mémoire morte 12 et des ordres d'un opérateur lui parvenant par l'intermédiaire de l'ensemble clavier afficheurs 11, la détermination d'un motif pour la configuration périodique d'un signal et l'élaboration d'un signal conforme au motif créé.

Lors de la détermination d'un motif de configuration périodique, en réponse à un ordre lui parvenant de l'ensemble clavier afficheurs 11 et lui précisant la composition des motifs précurseurs ao, bo, les lois récurrentes de types de motif de compositions définies par les décompositions, en motifs précurseurs ao, bo, des motifs a1, b1 résultant de la première application de ces lois, et le nombre d'itérations, le microprocesseur 10 crée dans la mémoire vive de travail 13 :
- un fichier Ao/Bo dit de motifs précurseurs pour mémoriser les valeurs d'échantillons composant les motifs précurseurs,
- un fichier A1/B1 dit de motifs anciens pour mémoriser les décompositions des motifs a1, b1 en motifs précurseurs ao, bo qui définissent les lois récurrentes de compositions de types de motif,
- un fichier A(n-1)/B(n-1) dit de motifs précédents pour mémoriser les décompositions en motifs précurseurs ao, bo des derniers motifs obtenus a(n-1), b(n-1),
- et un fichier An/Bn dit de motifs en cours dans lequel il inscrit au fur et à mesure les décompositions en motifs précurseurs ao, bo des motifs an, bn en cours de détermination.

Une fois l'ordre de création d'un motif et les fichiers de motifs précurseurs et de motifs anciens inscrits avec les données parvenant du clavier, le microprocesseur 10 commence la construction arborescente par une première itération au cours de laquelle il détermine les décompositions en motifs précurseurs ao, bo, des motifs a2, b2 et les inscrits au fur et à mesure de leurs déterminations dans le fichier de motifs précédents jouant provisoirement le rôle d'un fichier de motifs en cours. Il entame ensuite une deuxième itération au cours de laquelle il détermine les décompositions des motifs a3, b3 et les range dans le fichier de motifs en cours, puis poursuit la construction arborescente par d'autres itérations au début desquelles les rôles des fichiers de motifs précédents et en cours sont échangés, cela jusqu'à ce que le nombre d'itérations voulues ait été exécuté.

A chaque itération, le microprocesseur 10 détermine les décompositions en motifs précurseurs ao, bo des motifs en cours ai, bi en reprenant les décompositions en motifs précurseurs ao, bo des motifs anciens a1, b1 et en remplaçant dans ces décompositions, les motifs précurseurs, ao, bo par les décompositions des motifs précédents a(i-1); b(i-1) mémorisées dans le fichier de motifs précédents. Ainsi, avec l'exemple de signal décrit où les motifs anciens a1, b1 ont pour décomposition à titre d'exemple :
a1 = f (ao, bo) = ao bo ao
b1 = g (ao, bo) = bo bo bo
et en supposant que la construction arborescente en soit à la détermination des compositions des motifs intermédiaires ai, bi, celles des motifs précédents a(i-1), b(i-1) mémorisées dans le fichier de motifs précédents ayant les formes
a(i-1) = f (ao,bo)
b(i-1) = g (ao,bo)
le microprocesseur 10 détermine les compositions des motifs ai et bi en appliquant les relations :
ai = f (ai-1, bi-1) = f (ao, bo) g (ao, bo) f (ao, bo)
bi = g (ai-1, bi-1) = g (ao, bo) g (ao, bo) g (ao, bo)
Lors de l'élaboration du signal, le microprocesseur 10 lit séquentiellement, dans le dernier fichier de motifs en cours devenu un fichier de motif définif, la décomposition en motifs précurseurs (ao, bo) du motif "an", remplace, dans cette décomposition les motifs précurseurs ao, bo par les séquences d'échantillons qui les définissent et applique à une cadence régulière la suite des échantillons obtenus au convertisseur numérique-analogique 14 qui délivre le signal de sortie du générateur et comporte éventuellement en sortie un interface de puissance permettant d'adapter les caractéristiques du signal délivré à celles démandées par l'utilisation.

Les programmes de contrôle du microprocesseur inscrits dans la mémoire morte 12 pour assurer la gestion de l'ensemble clavier afficheurs 11 et du convertisseur numérique-analogique 14, ainsi que la création des fichiers et la manipulation de leurs contenus ne seront pas décrits car ils font partie de la technique courante des microprocesseurs.

Seuls les fichiers de motifs en cours et de motifs précédents prennent une certaine ampleur au cours des itérations. Avec l'exemple décrit et un arrêt de la construction après treize applications successives des lois récurrentes de composition de types de motif, le fichier de motifs précédents renferme à la fin de la détermination du motif de configuration périodique environs 2 fois 1,6 megabits et le fichier de motifs en cours environ 2 fois 5 megabits ce qui représente de 13,2 mégabits ou 1,7 mégaoctets et qui est à la portée d'un microordinateur de type courant.

On peut, sans sortir du cadre de la présente invention, modifier certaines dispositions ou remplacer certains moyens par des moyens équivalents.

Ainsi, on peut mémoriser dans le fichier des motifs anciens, non pas les motifs (a1, b1) résultant de la première application aux motifs précurseurs (ao, bo) des lois récurrentes de composition de types de motif mais des motifs intermédiaires (ai, bi) résultant de plusieurs applications successives des lois récurrentes. On obtient alors, au prix d'une augmentation de la capacité du fichier de motifs anciens, une diminution du nombre d'itérations nécessaires pour le même nombre d'applications des lois récurrentes de composition de types motifs et par conséquent un accroissement de la vitesse de création d'un motif de configuration périodique d'un signal.

Une telle augmentation de vitesse est avantageusement utilisée dans le traitement optique de l'information.

En outre, les séquences de définition des motifs précurseurs ao, bo peuvent être réduites à un seul échantillon de niveau de signal ou en comporter plus de trois, les motifs précurseurs comme les lois récurrentes de compositions de types de motif pouvant être quant à eux en nombres supérieurs à deux.

## Revendications

1. Générateur de signal temporel périodique dont le motif de configuration périodique est défini par un arrangement de motifs précurseurs (ao, bo...) résultant d'une construction récurrente mettant en oeuvre, par itérations, plusieurs lois récurrentes de compositions de types motif et consistant à définir le dit motif de configuration périodique comme l'une des composantes "an" du n ième terme Un à m composantes (an, bn,...), m étant un entier plus grand que 1, d'une suite récurrente, ledit n ième terme Un étant défini au niveau de chacune de ses composantes (an, bn...) en fonction des composantes (a(n-1), b(n-1)...) du terme précédent U(n-1) par m lois récurrentes de composition de types de motif par concaténation des composantes (a(n-1), b(n-1),...) du terme précédent U(n-1) et le terme initial Uo de la suite ayant pour composantes les motifs précurseurs (ao, bo...), ledit générateur comportant un microprocesseur (10) associé à une mémoire de travail (13) renfermant un fichier de motif définitif qui contient un arrangement final de motifs précurseurs constituant ledit motif de configuration périodique et qui est lu de manière répétitive lors de la délivrance du signal, et à un périphérique de sortie (14) délivrant le dit signal avec des valeurs successives en accord avec celles des motifs précurseurs lus dans le fichier de motif définitif, et dans lequel la mémoire de travail renferme au moins trois fichiers lors de la détermination d'un motif de configuration périodique d'un signal :
- un fichier (A1/B1) dit de motifs anciens mémorisant les décompositions en motifs précurseurs (ao, bo) de motifs anciens (a1, b1) résultant d'au moins une application aux motifs précurseurs (ao, bo), des lois récurrentes de composition de types de motif,
- un fichier (An-1/Bn-1) dit de motifs précédents mémorisant les décompositions en motifs précurseurs (ao, bo) des motifs (a(n-1), b(n-1)) obtenus au cours de l'étape d'itération précédent celle en cours,
- et un fichier (An/Bn) dit de motifs en cours dans lequel les décompositions des motifs (an, bn) en cours de détermination sont inscrites au fur et mesure, ces décompositions étant obtenues en reprenant celles des motifs anciens, lues dans le fichier (A1/B1) de motifs anciens et en remplaçant dans ces dernières les motifs précurseurs par les décompositions des motifs précédents de mêmes types lues dans le fichier (An-1/Bn-1) de motifs précédents.

2. Générateur selon la revendication 1, caractérisé en ce que le fichier (A1/B1) de motifs anciens renferme les décompositions en motifs précurseurs (ao, bo) des motifs (a1, b1) résultant de la première application des lois récurrentes de composition de types de motif.

## Claims

1. Periodic temporal signal generator, wherein the periodic configuration pattern is defined by an arrangement of seed patterns (a0, b0, etc) resulting from a recurrent construction using in an iterative way a number of recurrent pattern type composition laws and consisting in defining said periodic configuration pattern as one of the components "an" of the nth term Un with m components (an, bn, etc) where m is an integer greater than one, of a recurrent sequence, said nth term Un being defined, at the level of each of its components (an, bn, etc) according to the components (a(n-1), b(n-1), etc) of the preceding term U(n-1) by m recurrent pattern type composition laws by means of a concatenation of the components a(n-1), b(n-1) of the previous term U(n-1), and the initial term U0 of the sequence having for its components the seed patterns a0, b0, etc, said generator comprising a microprocessor (10) associated with a working memory (13) storing a definitive pattern file which contains a final arrangement of seed patterns constituting said periodic configuration pattern and which is read repetitively when delivering the signal, and with an output peripheral device (14) supplying said signal with successive values agreeing with those of the seed patterns read in the definitive patterns file, and wherein the working memory contains at least three files during determination of a signal periodic configuration pattern:
- an old patterns file (A1/B1) storing the breakdowns into seed patterns (a0, b0) of the old patterns (a1, b1) resulting from at last one application to the seed patterns (a0, b0) of the recurrent pattern type composition laws,
- a previous patterns file (An-1/Bn-1) storing the breakdowns into seed patterns a0, b0 of the patterns (a(n-1), b(n-1)) obtained during the iteration step preceding the current one, and
- a current patterns file (An/Bn) in which the breakdowns of the patterns (An, Bn) during the determination are written as and when they appear, these breakdowns being obtained on the basis of the old patterns read in the old patterns file (A1/B1) and replacing in the latter the seed patterns with the breakdowns of the preceding patterns of the same kind read in the previous patterns file (An-1/Bn-1).

2. A generator according to claim 1 characterized in that the old patterns file (A1/B1) contains the breakdowns into seed patterns (a0, b0) of the patterns (a1, b1) resulting from the first application of the recurrent pattern type composition law.

## Patentansprüche

1. Generator für periodische Zeitsignale, deren periodisches Konfigurationsmotiv durch eine Anordnung von Präkursormotiven (ao, bo, ...) definiert wird, die aus einer rekursiven Konstruktion durch iterative Anwendung von mehreren rekursiven Kompositionsgesetzen für Motivtypen resultieren, wobei das periodische Konfigurationsmotiv als eine der Komponenten "an" des n-ten Glieds Un mit m Komponenten einer rekursiven Folge (an bn, ...) definiert wird, wobei m eine ganze Zahl größer als 1 ist, wobei das n-te Glied Un in Höhe jeder seiner Komponenten (an, bn, ..) abhängig von den Komponenten (a(n-1), b(n-1)...) des vorhergehenden Glieds U(n-1) durch m rekursive Kompositionsgesetze für Motivtypen durch Verkettung der Komponenten (a(n-1), b(n-1), ...) des vorhergehenden Glieds U(n-1) definiert wird, und wobei das Anfangs-Glied Uo der Folge die Präkursormotive (ao, bo, ..) als Komponenten hat und der Generator einen Mikroprozessor (10) aufweist, der einem Arbeitsspeicher (13) zur Speicherung einer Datei des definitiven Motivs, die eine endgültige Anordnung von das periodische Konfigurationsmotiv bildenden Präkursormotiven enthält und während der Ausgabe des Signals wiederholt ausgelesen wird, und einer Ausgabeschaltung (14) zugeordnet ist, die das Signal mit aufeinanderfolgende Werten in Einklang mit denen der aus der definitiven Motivdatei ausgelesenen Präkursormotive liefert, und wobei der Arbeitsspeicher mindestens drei Dateien während der Bestimmung eines periodischen Konfigurationsmotivs eines Signals umfaßt, nämlich:
- eine Datei (A1/B1) der alten Motive, die Zerlegungen von alten Motiven (a1, b1) in Präkursormotive (ao, bo) speichert aufgrund mindestens einer Anwendung der rekursiven Kompositionsgesetze für Motivtypen auf die Präkursormotive (ao, bo),
- eine Datei (An-1/Bn-1) der vorhergehenden Motive, die die Zerlegungen der während der dem laufenden Verfahrensschritt vorausgehenden Iterationsschritt erhaltenen Motive (a(n-1), b(n-1)) in Präkursormotive (ao, bo) speichert,
- und eine Datei (An/Bn) der aktuellen Motive, in die die gerade bestimmten Zerlegungen der Motive (an, bn) im Rhythmus ihrer Entstehung eingeschrieben werden, wobei diese Zerlegungen erhalten werden, indem man die der alten Motive, die aus der Datei (A1/B1) der alten Motive ausgelesenen werden, aufgreift und in diesen letzteren die Präkursormotive durch die Zerlegungen der vorhergehenden Motive derselben Typen ersetzt, die aus der Datei (An-1/Bn-1) von vorhergehenden Motiven ausgelesen worden sind.

2. Generator nach Anspruch 1, dadurch gekennzeichnet, daß die Datei (A1/B1) von alten Motiven die Zerlegungen in Präkursormotive (ao, bo) der aus der ersten Anwendung der rekursiven Kompositionsgesetze von Motivtypen enthält.
